# EUROPEAN PATENT APPLICATION

(11) **EP 4 340 168 A1**
(43) Date of publication of application: **20.03.2024**
(21) Application number: 22870110.8
(22) Date of filing: 12.07.2022
(51) Int. Cl.: H02J 7/00, G01R 19/165, G01R 31/382

(54) **CELL BALANCING CIRCUIT AND BATTERY SYSTEM COMPRISING THE SAME**

(30) Priority: 14.09.2021 KR 20210122355
(71) Applicant: LG Energy Solution, Ltd., Seoul 07335 (KR)
(72) Inventor: SUNG, Chang Hyun, Daejeon 34122 (KR)
(74) Representative: Plasseraud IP
(86) International application number: PCT/KR2022/010084
(87) International publication number: WO 2023/043023

(57) **Abstract**

A cell balancing circuit connected to a plurality of cells connected in series includes: a first switch, a first winding wire, and a second switch coupled in series between both terminals of a central battery cell including a centrally positioned cell in a plurality of cells; and a third switch, a second winding wire, and a fourth switch coupled in series between a positive electrode of one and a negative electrode of the other one of the outer battery cells except the central battery cell among the plurality of cells. The first winding wire and the second winding wire may form a transformer. During the charge or discharge, in a condition that the cell voltage difference between the central battery cell and the outer battery cell is greater than or equal to a predetermined threshold value, during the ON period of the first switch and the second switch, a first side current as a part of a charging current or a discharging current flows through the first switch, the first winding wire, and the second switch.

## Description

### [Technical Field]

### CROSS-REFERENCE TO RELATED APPLICATION

This application claims priority to and the benefit of Korean Patent Application No. 10-2021-0122355 filed in the Korean Intellectual Property Office on September 14, 2021, the entire contents of which are incorporated herein by reference.

The present disclosure relates to a cell balancing circuit and a battery system including the same.

### [Background Art]

Inside a battery pack, a plurality of battery cells are connected in series or in parallel. Voltage deviation between the battery cells may cause over-discharge or over-charge of the battery cells, and also reduce lifetime of the battery cells. A cell balancing circuit is designed in a battery management system (BMS) to improve the voltage deviation.

As the cell balancing circuit, a passive cell balancing circuit that maintains a balance between battery cells by consuming energy of a battery cell with a relatively high voltage as heat of resistance may be used. In this case, there is a problem in that it is difficult to increase a balancing current in accordance with the trend of increasing the capacity of the battery cell because the balancing current is limited due to heat through a resistor. To address this issue, an active cell balancing circuit has been proposed that transfers the energy of a battery cell with a relatively high voltage to a battery cell with a relatively low voltage. However, since many elements are required to implement the active cell balancing circuit, there is a problem that the cost of the cell balancing circuit is increased.

### [Disclosure]

### [Technical Problem]

The task to be achieved by the present invention is to provide a cell balancing circuit capable of reducing the number of parts of the cell balancing circuit, and thus reducing a unit cost, and a battery system including the same.

### [Technical Solution]

A cell balancing circuit connected to a plurality of cells connected in series includes: a first switch, a first winding wire, and a second switch coupled in series between both terminals of a central battery cell including a centrally positioned cell in a plurality of cells; and a third switch, a second winding wire, and a fourth switch coupled in series between a positive electrode of one and a negative electrode of the other one of the outer battery cell except the central battery cell among the plurality of cells. The first winding wire and the second winding wire may form a transformer. During the charge or discharge, in a condition that the cell voltage difference between the central battery cell and the outer battery cell is greater than or equal to a predetermined threshold value, during the ON period of the first switch and the second switch, a first side current as a part of a charging current or a discharging current may flow through the first switch, the first winding wire, and the second switch.

In a condition that the cell voltage difference between the central battery cell and the outer battery cell during the charging is greater than or equal to a predetermined threshold value, the first switch and the second switch may be turned-on, an on duty of the first switch and the second switch may be controlled based on the current flowing to the first winding wire, and the third switch and the fourth switch may be turned-on after the turning-off of the first switch and the second switch.

In a condition that the cell voltage difference between the central battery cell and the outer battery cell during the charging is greater than or equal to a predetermined threshold value, in a turning on state of the first switch and the second switch, the first side current reaches a predetermined reference value, and the first switch and the second switch may be turned-off.

In a condition that the cell voltage difference between the central battery cell and the outer battery cell during the discharging is equal to or greater than a predetermined threshold value, the third switch and the fourth switch may be turned-on, an on duty of the third switch and the fourth switch may be controlled based on the current flowing to the first winding wire, and the first switch and the second switch may be turned-on after the turning-off of the third switch and the fourth switch.

In a condition that the cell voltage difference between the central battery cell and the outer battery cell during the discharge is equal to or greater than a predetermined threshold value, in the turning on state of the third switch and the fourth switch, when the second side current reaches a predetermined reference value, the third switch and the fourth switch may be turned-off.

The cell balancing circuit may further include: a first diode connected between one terminal of the first switch and one terminal of the first winding wire; and a second diode connected between one terminal of the second switch and the other terminal of the first winding wire, the other terminal of the first switch may be connected to the other terminal of the first winding wire, and the other terminal of the second switch may be connected to one terminal of the first winding wire.

The cell balancing circuit may further include a third diode connected between one terminal of the third switch and one terminal of the second winding wire, and a fourth diode connected between one terminal of the fourth switch and the other terminal of the second winding wire, the other terminal of the third switch may be connected to the other terminal of the second winding wire, and the other terminal of the fourth switch may be connected to one terminal of the second winding wire.

A battery system according to another feature of the invention includes: a battery pack including a plurality of cells connected in series; a cell monitoring IC for measuring a cell voltage of each of a plurality of cells; a main control circuit that determines whether a deviation between a cell voltage of a central battery cell including the cell centrally positioned among a plurality of cells and cell voltage of an outer battery cell except for the central battery cell among a plurality of cells is a predetermined threshold value or more based on a plurality of measured cell voltages, and controls a cell balancing operation based on the determined result and the charging and discharging of the battery pack; and a cell balancing circuit that prevents a first current among a charging current from flowing to the central battery cell when the deviation is greater than the threshold value in the charging condition of the battery pack, and prevents a second current among a discharging current from flowing to the central battery cell when the deviation is greater than the threshold value in the discharge condition of the battery pack.

The cell balancing circuit may include: a first switch, a first winding wire, and a second switch coupled in series between both terminals of the central battery cell; and a third switch, a second winding wire, and a fourth switch coupled in series between a positive electrode of one and a negative electrode of the other one among the outer battery cells, and the first winding wire and the second winding wire may form a transformer.

The cell balancing circuit may switch the first to fourth switches during a first period in which the deviation is larger than the threshold value during the charging period to store the energy in the first winding wire by the first current and to transmit the stored energy in the first winding wire to the second winding wire.

During the first period, a first current may flow in the first winding wire during an ON period of the first and second switches, and a current is induced to the second winding wire during an OFF period of the first and second switches and an ON period of the third and fourth switches.

The cell balancing circuit may switch the first to fourth switches during a second period in which the deviation is larger than the threshold value among the discharge period to store the energy in the second winding wire and to transmit the stored energy in the second winding wire to the first winding wire.

During the second period, a current may flow in the second winding wire during an ON period of the third and fourth switches, and a second current is induced to the first winding wire during an OFF period of the third and fourth switches and an ON period of the first and second switches.

The cell balancing circuit may include: a first diode connected between one terminal of the first switch and one terminal of the first winding wire; and a second diode connected to one terminal of the second switch and the other terminal of the first winding wire, the other terminal of the first switch may be connected to the other terminal of the first winding wire, and the other terminal of the second switch may be connected to one terminal of the first winding wire.

The cell balancing circuit may further include a third diode connected between one terminal of the third switch and one terminal of the second winding wire, and a fourth diode connected between one terminal of the fourth switch and the other terminal of the second winding wire, the other terminal of the third switch may be connected to the other terminal of the second winding wire, and the other terminal of the fourth switch may be connected to one terminal of the second winding wire.

### [Advantageous Effects]

According to an embodiment of the present invention, the cell balancing circuit capable of reducing the number of components of the cell balancing circuit, and thus reducing the unit cost, and the battery system including the same, are provided.

### [Description of the Drawings]

FIG. 1 is a view schematically showing a battery system according to an embodiment.
FIG. 2 is a view showing a configuration of a cell balancing circuit according to an embodiment.
FIG. 3 and FIG. 4 are views schematically showing a cell balancing circuit during a cell balancing operation during charging a battery pack according to an embodiment.
FIG. 5 and FIG. 6 are views schematically showing a cell balancing circuit during a cell balancing operation during discharging a battery pack according to an embodiment.

### [Mode for Invention]

Suffixes, "module" and/or "unit" for a constituent element used for the description below are given or mixed in consideration of only easiness of the writing of the specification, and the suffix itself does not have a discriminated meaning or role. In addition, the terms "-er", "-or", and "module" described in the specification mean units for processing at least one function and operation, and can be implemented by hardware components or software components, and combinations thereof.

Further, in describing the embodiments disclosed in the present disclosure, when it is determined that detailed description relating to well-known functions or configurations may make the subject matter of the embodiment disclosed in the present disclosure unnecessarily ambiguous, the detailed description will be omitted. Further, the accompanying drawings are provided for helping to easily understand embodiments disclosed in the present specification, and the technical spirit disclosed in the present specification is not limited by the accompanying drawings, and it will be appreciated that the present invention includes all of the modifications, equivalent matters, and substitutes included in the spirit and the technical scope of the present invention.

Terms including an ordinary number, such as first and second, are used for describing various constituent elements, but the constituent elements are not limited by the terms. The terms are used only to discriminate one constituent element from another constituent element.

It should be understood that when one constituent factor is referred to as being "coupled to" or "connected to" another constituent factor, one constituent factor can be directly coupled to or connected to the other constituent factor, but intervening factors may also be present. By contrast, when one constituent factor is referred to as being "directly coupled to" or "directly connected to" another constituent factor, it should be understood that there are no intervening factors.

In the present application, it will be appreciated that terms "including" and "having" are intended to designate the existence of characteristics, numbers, steps, operations, constituent elements, and components described in the specification or a combination thereof, and do not exclude a possibility of the existence or addition of one or more other characteristics, numbers, steps, operations, constituent elements, and components, or a combination thereof in advance.

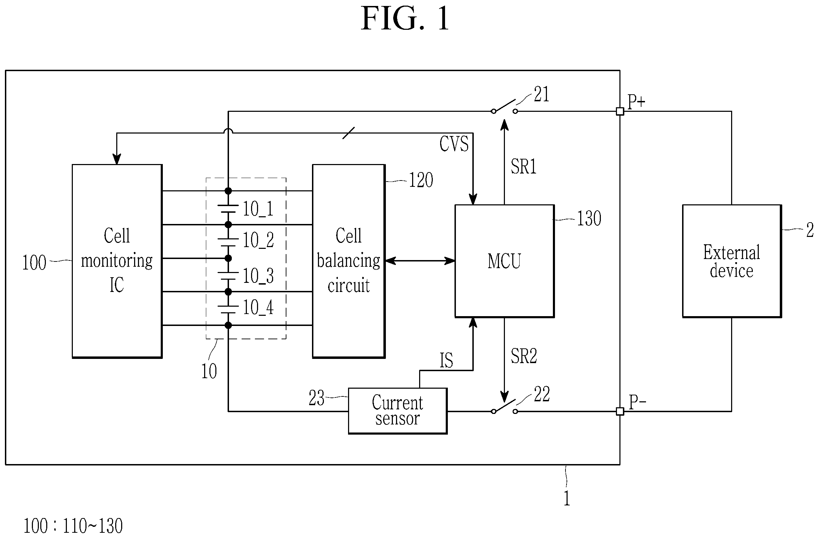

FIG. 1 is a view schematically showing a battery system according to an embodiment.

In FIG. 1, an external device 2 is connected between both output terminals P+ and P- of the battery system 1, and when relays 21 and 22 are closed, a battery pack 10 and an external device 2 may be electrically connected.

When the external device 2 is an electrical load, the battery system 1 may be discharged by operating as a power supply that supplies energy to the electrical load 2. The electrical load may be a transportation means or an energy storage system (ESS), and the transportation means may be, for example, an electric vehicle, a hybrid vehicle, or smart mobility. When the external device 2 is a charger, the battery system 1 may be charged by supplying the energy from the power system through the charger 2.

The battery system 1 includes a battery pack 10, two relays 21 and 22, a current sensor 23, and a battery management system (BMS) 100.

The battery pack 10 includes a plurality of battery cells 10_1 to 10_4 connected in series. In FIG. 1, the battery pack 10 is illustrated as including four battery cells 10_1 to 10_4 connected in series, but this is an example and the invention is not limited thereto. For example, five or more battery cells may be connected in series, or a plurality of battery cells in which two or more are connected in parallel may be connected in series.

The relay 21 is connected between the positive electrode of the battery pack 10 and the output terminal P+, the relay 22 is connected between the negative electrode of the battery pack 10 and the output terminal P-, and the opening and closing of the relays 21 and 22 may be controlled depending on the control of the main control unit (MCU) 130 of the BMS 100. For example, the MCU 130 may generate the relay control signals SR1 and SR2 of an enable level and transmit them to the relays 21 and 22, and the relays 21 and 22 may be closed by the enable level relay control signals SR1 and SR2. Alternatively, the MCU 130 may generate the relay control signals SR1 and SR2 of the disable level and transmit them to the relays 21 and 22, and the relays 21 and 22 may be opened by the relay control signals SR1 and SR2 of the disable level. During the charge or the discharge of battery pack 10, the relays 21 and 22 are closed to configure a charging current path or a discharging current path.

The current sensor 23 may detect a current flowing in the battery pack 10 and may transmit a current detection signal (IS) indicating the detected current to the MCU 130.

The BMS 20 may include a cell monitoring IC 110, a cell balancing circuit 120, and the MCU 130. The BMS 20 may be connected to a plurality of battery cells 10_1 to 10_4, control the charging and discharging current of the battery 10 based on the information such as each cell voltage of a plurality of battery cells 10_1 to 10_4, the battery current of the battery pack 10, etc., and control the cell balancing operation for a plurality of battery cells 10_1 to 10_4.

For example, the cell monitoring IC 110 may measure a cell voltage of each of a plurality of battery cells 10_1 to 10_4 at each measurement period, and transmit a cell voltage detection signal CVS indicating a plurality of measured cell voltages to the MCU 130. The MCU 130 may determine whether the cell balancing is necessary based on the cell voltage detection signal CVS.

During the charge or discharge, the lowest cell voltage among the cell voltages of a plurality of battery cells 10_1 to 10_4 may be lower than other cell voltages by a predetermined threshold value or more, or the highest cell voltage may be higher than other cell voltages by a predetermined threshold value or more. As such, when the deviation between the cell voltages of a plurality of battery cells 10_1 to 10_4 is equal to or greater than a predetermined threshold value, the MCU 130 may determine that the cell balancing is necessary.

Also, when the voltage deviation between the central battery cell and the outer battery cell is equal to or greater than a predetermined threshold value, the MCU 130 may determine that the cell balancing is necessary. The central battery cell may include a central battery cell (e.g., 10_2, 10_3 among a plurality of cells 10_1 to 10_4 of the battery pack 10, and the central battery cell may be positioned in the center of a plurality of cells. In FIG. 1, the battery cells 10_2 and 10_3 correspond to the central battery cell, and the outer battery cell includes the remaining cell (e.g., 10_1, 10_4) except for the central cell of the battery pack 10, and the outer battery cell may be positioned near the positive electrode and the negative electrode. In FIG. 1, the battery cells 10_1 and 10_4 correspond to the outer battery cell.

In FIG. 1, the battery pack 10 consists of four battery cells 10_1 to 10_4, and only two central battery cells 10_2 and 10_3 and two outer battery cells 10_1 and 10_4 are shown, but the invention is not limited thereto. A predetermined number of the battery cells positioned in the center among the entire battery cells constituting the battery pack may be the central battery cells, and the remaining cells excluding the central battery cell among the entire battery cells may be the outer battery cells.

Hereinafter, the cell balancing described in the present specification may means the charge balancing operation performed between the central battery cell and the outer battery cell when the voltage deviation between the central battery cell and the outer battery cell is the predetermined threshold value or more.

When it is determined that the cell balancing is necessary, the MCU 130 may control the cell balancing circuit 120 so that the charge current or the discharging current flowing to the central cells 10_2 and 10_3 is reduced. The MCU 130 may determine whether it is in a charging state or a discharging state based on the current detection signal IS. In the charging state, the MCU 130 may allow the charging current to flow through the first power transferring path coupled in parallel to the central battery cells 10_2 and 10_3. The energy generated by the charging current flowing through the first power transferring path may be transferred to the entire battery pack 10. In the discharging state, the MCU 130 may allow the discharging current to flow through a second power transferring path coupled in parallel to the battery pack 10. The discharging current flowing through the central battery cell 10_2 and 10_3 is reduced by the discharging current flowing through the second power transferring path.

Hereinafter, the cell balancing performed in the charging state is referred to as 'a cell balancing during the charging', and the cell balancing performed in the discharging state is referred to as 'a cell balancing during the discharging'.

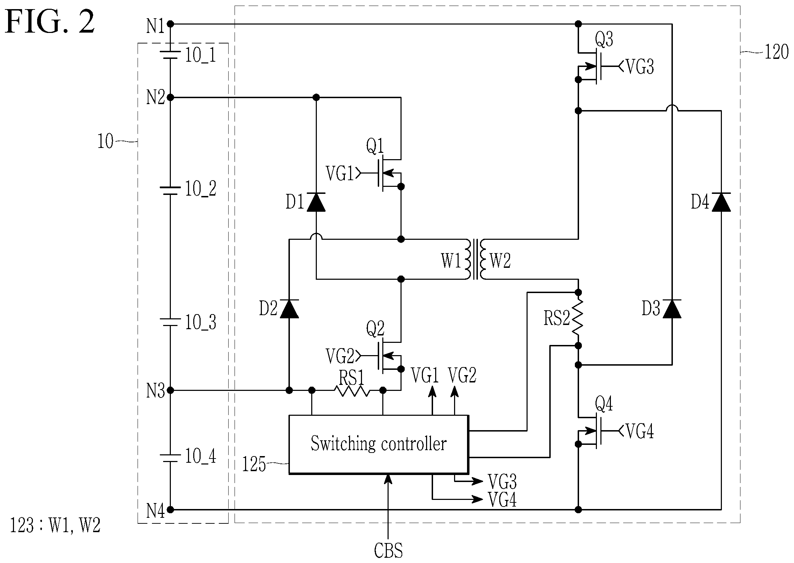

Next, the cell balancing circuit according to an embodiment is described with reference to FIG. 2.

FIG. 2 is a view showing a configuration of a cell balancing circuit according to an embodiment.

In FIG. 2, the cell balancing circuit 120 includes four switches Q1 to Q4, four diodes D1 to D4, a transformer 123, and a switching control unit 125. The first winding wire W1 and the second winding wire W2 are magnetically coupled in an isolation state to form the transformer 123. In the transformer 123, the place where the first winding wire W1 is positioned may be called a first side, and the place where the second winding wire W2 is positioned may be called a second side.

The switch Q1 is connected between a node N2 connected between the battery cell 10_1 and the battery cell 10_2, and one terminal of the first winding wire W1, and the switch Q2 is connected between a node N3 connected between the battery cell 10_3 and the battery cell 10_4, and the other terminal of the first winding wire W1. The switch Q1, the first winding wire W1, and the switch Q2 may constitute the first power transferring path.

The switch Q3 is connected between the node N1 which is the positive electrode of the battery cell 10_1 and one terminal of the second winding wire W2, and the switch Q4 is connected between the node N4 which is the negative electrode of the battery cell 10_4 and the other terminal of the second winding wire W2. The switch Q3, the second winding wire W2, and the switch Q4 may compose the second power transferring path.

In FIG. 2, the switches Q1 to Q4 are implemented as n-channel type of MOSFETs, but this is an example of the present invention and it is not limited thereto. The gate voltages VG1-VG4 supplied from the switching control unit 125 may be applied to the gates of the four switches Q1 to Q4, respectively.

The anode of the diode D1 is connected to the other terminal of the first winding wire W1, and the cathode of the diode D1 is connected to the drain of the switch Q1. The diode D1 may protect the switch Q1 from the electromotive force induced by the leakage inductance of the first side of the transformer 123. The anode of the diode D2 is connected to the source of the switch Q2, and the cathode of the diode D2 is connected to one terminal of the first winding wire W1. The diode D2 may protect the switch Q2 from the electromotive force induced by the leakage inductance of the first side of transformer 123.

The anode of the diode D3 is connected to the other terminal of the second winding wire W2, and the cathode of the diode D3 is connected to the drain of the switch Q3. The diode D3 may protect the switch Q3 from the electromotive force induced by the leakage inductance of the second side of the transformer 123. The anode of the diode D4 is connected to the source of the switch Q4, and the cathode of the diode D4 is connected to one terminal of the second winding wire W2. The diode D4 may protect the switch Q4 from electromotive force induced by leakage inductance on the second side of the transformer 123.

The switching control unit 125 may receive the cell balancing control signal CBS from the MCU 130 and control the switching operation of the four switches Q1 to Q4 based on the cell balancing control signal CBS. In the embodiment shown in FIG. 2, four switches Q1 to Q4 and the transformer 123 may configure a both--direction flyback converter structure. When the cell balancing control signal CBS instructs the cell balancing during the charging, the switching control unit 125 may control the switching operation of the four switches Q1 to Q4 so that the energy is transferred from the first side to the second side. When the cell balancing control signal CBS instructs the cell balancing during the discharging, the switch control unit 125 may control the switching operation of the four switches Q1 to Q4 so that the energy is transferred from the second side to the first side.

The switching control unit 125 may control an on duty of the switches Q1 to Q4 during each period of the cell balancing during the charging and the cell balancing during the discharging depending on the current (hereinafter, a first side current) flowing to the first side and the current (hereinafter, a second side current) flowing to the second side.

The switching control unit 125 may use the voltage (hereinafter, a first sensing voltage) VS1 across the both terminals of the resistor RS1 and the voltage (hereinafter, a second sensing voltage) VS2 across the both terminals of the resistor RS2 to sense the current of each of the first side and the second side. The switching control unit 125 generates gate voltages VG1-VG4 to control the switching operation of the switches Q1 to Q4 and supplies them to the gates of the switches Q1 to Q4. The switching control unit 125 may generate the gate voltages VG1-VG4 of a high level to turn on the switches Q1 to Q4 and gate voltages VG1-VG4 of a low level to turn the switches Q1 to Q4 off.

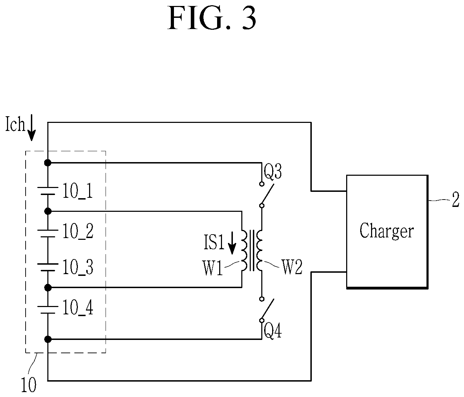

Hereinafter, the operation of the cell balancing circuit according to an embodiment is described with reference to FIG. 3 to FIG. 6.

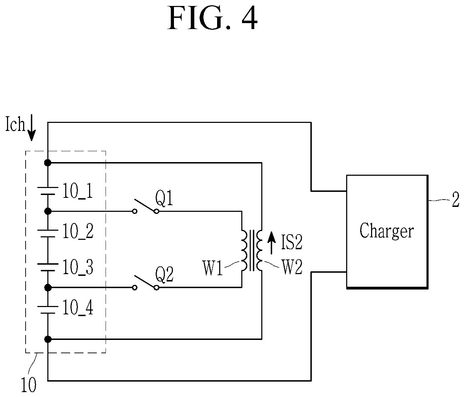

FIG. 3 and FIG. 4 are views schematically showing a cell balancing circuit among a cell balancing operation during a charging operation of a battery pack according to an embodiment.

Referring to FIG. 3 and FIG. 4, the battery pack 10 is connected to the charger 2, and the battery pack 10 is charged by the current supplied from the charger 2. FIG. 3 and FIG. 4 may be views showing the cell balancing operation during the charging of the cell balancing circuit 120 during one switching cycle.

When the deviation between the cell voltage of the central battery cell and the cell voltage of the outer battery cell during the charging is the threshold value or more, the MCU 130 transmits the cell balancing control signal CBS instructing the cell balancing during the charging to the switching control unit 125. For example, the MCU 130 may generate the first level cell balancing control signal CBS, and the switching control unit 125 may perform the cell balancing during the charging during the period that the cell balancing control signal CBS of the first level is received from the MCU 130.

First, as shown in FIG. 3, the switching control unit 125 turns off the switches Q3 and Q4 for the cell balancing during the charging, and controls the on-duties of the switches Q1 and Q2 based on the first side current IS1. During the ON period of the switches Q1 and Q2, the first side current IS1 flows to the first winding wire W1, and the energy is stored in the first winding wire W1. During the ON period of the switches Q1 and Q2, the first side current IS1 may increase.

The switching control unit 125 may derive the energy stored in the first winding wire W1 based on the first side current IS1 and the period when the first side current IS1 flow, and control the on-duties of the switches Q1 and Q2 so that the value obtained by dividing the derived energy by the switching cycle is a predetermined reference value. As a specific means for this, the switching control unit 125 may turn off the switches Q1 and Q2 when the first sensing voltage VS1 reaches a predetermined first reference voltage.

The switching control unit 125 turns off the switches Q1 and Q2, and then turns on the switches Q3 and Q4. Then, a second side current IS2 is induced in the second winding wire W2. The second side current IS2 is supplied to the battery pack 10 together with the charging current Ich supplied from the charger 2. During the ON period of the switches Q3 and Q4, the second side current IS2 may decrease. The switching control unit 125 controls the on-duties of the switches Q3 and Q4 based on the second side current IS2. For example, when the second sensing voltage VS2 reaches a predetermined second reference voltage, the switching control unit 125 may turn off the switches Q3 and Q4, and the second reference voltage may be a zero voltage.

The energy is transmitted from the central battery cells 10_2 and 10_3 to the battery pack 10 during the ON period of the switches Q3 and Q4. That is, the charging current Ich and the second side current IS2 may be supplied to the battery pack 10.

During the ON period of the switches Q1 and Q2, the first side current IS1 among the charging current Ich does not flow to the central battery cells 10_2 and 10_3, and flows only to the outer battery cells 10_1 and 10_4. This may reduce the heat generation of the central battery cells 10_2 and 10_3. In the conventional battery pack, the central battery cell has a higher temperature than the outer battery cell, so the deterioration of the central battery cell is more severe than that of the outer battery cell. Because of this, the central battery cell is first fully charged and the charging is terminated before all cells are fully charged. However, according to the cell balancing according to an embodiment, as much as the first side current IS1 among the charging currents supplied to the battery pack 10 is not supplied to the central battery cell, the charging speed of the central battery cell may be slower than the charging speed of the outer battery cell. Then, the conventional problem that the charging is terminated before all cells are charged may be solved.

The switching control unit 125 may turn on the switches Q1 and Q2 again after the turn-off of the switches Q3 and Q4. The operation after the turn-on of the switches Q1 and Q2 is the same as described above. The switching control unit 125 according to an embodiment may control the switching operation of the switches Q1 to Q4 with a constant switching frequency. However, the present invention is not limited thereto, and the switching control unit 125 may change the switching frequency for the cell balancing during the charging. The present invention may control the first side current IS1 by changing at least one of the on-duty and the switching frequency.

The switching control unit 125 repeats the above operation while the cell balancing control signal CBS is at the first level.

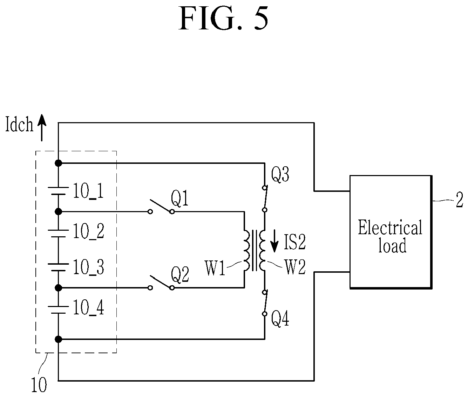

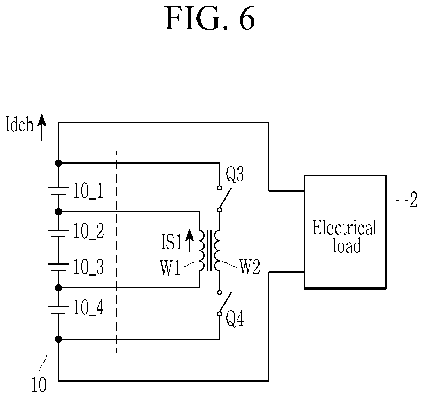

FIG. 5 and FIG. 6 are views schematically showing a cell balancing circuit during cell balancing during a discharging operation of a battery pack according to an embodiment.

In FIG. 5 and FIG. 6, the battery pack 10 is connected to the electric load 2, the current is supplied from battery pack 10 to the electric load 2, and the battery pack 10 is discharged. FIG. 5 and FIG. 6 may be the views showing the cell balancing operation during the discharging during one switching cycle of the cell balancing circuit 120.

The MCU 130 transmits the cell balancing control signal CBS instructing the cell balancing during the discharging to the switching control unit 125 when the deviation between the cell voltage of the central battery cell and the cell voltage of the outer battery cell is the threshold value or more during the discharging. For example, the MCU 130 may generate the cell balancing control signal CBS of the second level, and the switching control unit 125 may perform the cell balancing during the discharging during the period in which the cell balancing control signal CBS of the second level is received from the MCU 130.

First, as shown in FIG. 5, the switching control unit 125 may turn off the switches Q1 and Q2 for the cell balancing during the discharging, and control the on-duties of the switches Q3 and Q4 based on the first side current IS1. During the ON period of the switches Q3 and Q4, the second side current IS2 flows to the second winding wire W2, and the energy is stored in the second winding wire W2. During the ON period of the switches Q3 and Q4, the second side current IS2 may increase.

The switching control unit 125 may derive the energy transmitted to the first winding wire W1 based on the period in which the first side current IS1 and the first side current IS1 flow among the ON period of the switches Q1 and Q2 after the turn-off of the switches Q3 and Q4 in the current switching cycle. The switching control unit 125 may control the on-duties of the switches Q3 and Q4 in the next switching cycle so that a value obtained by dividing the derived energy by the switching cycle is a predetermined reference value. As a specific means for this, the switching control unit 125 may turn off the switches Q3 and Q4 when the second sensing voltage VS2 reaches a predetermined third reference voltage. That is, the third reference voltage may be set such that a value obtained by dividing the energy transmitted to the first winding wire W1 by the switching cycle is a predetermined reference value.

The switching control unit 125 turns off the switches Q3 and Q4 and then turns on the switches Q1 and Q2. Then, the first side current IS1 is induced in the first winding wire W1, and the first side current IS1 of the discharging current Idch does not flow to the central cells 10_2 and 10_3. The first side current IS1 flowing during the ON period of the switches Q1 and Q2 may decrease. The switching control unit 125 controls the on-duties of the switches Q1 and Q2 based on the first side current IS1. For example, the switching control unit 125 may turn off the switches Q1 and Q2 when the first sensing voltage VS1 reaches a predetermined fourth reference voltage, and the fourth reference voltage may be a zero voltage.

During the ON period of the switches Q1 and Q2, the first side current IS1 of the discharging current Idch does not flow in the central battery cells 10_2 and 10_3, but flows only in the outer battery cells 10_1 and 10_4. This may reduce the heat generation of the central battery cells 10_2 and 10_3. In the conventional battery pack, the central battery cell has a higher temperature than the outer battery cell, so the deterioration of the central battery cell is more severe than that of the outer battery cell. For this reason, the central battery cell is discharged first, so that the discharge is terminated, and there may be a limit in supplying the power to the electric load. However, according to the cell balancing according to an embodiment, the first side current IS1 among the entire current supplied from the battery pack 10 does not flow to the central battery cells 10_2 and 10_3, so the discharge speed of the central battery cell may be slower than the discharge speed of the outer battery cell. Then, the problem that the conventional central battery cells are discharged first and the discharge is terminated may be solved.

The switching control unit 125 may turn on the switches Q3 and Q4 again after the turning-off of switches the Q1 and Q2. The operation after the turning-on of the switches Q3 and Q4 is the same as described above. The switching control unit 125 according to an embodiment may control the switching operation of the switches Q1 to Q4 with a constant switching frequency. However, the present invention is not limited thereto, and the switching control unit 125 may change the switching frequency for the cell balancing during the discharging. The present invention may control the first side current IS1 by changing at least one of the on-duty and the switching frequency.

The switching control unit 125 repeats the above operation while the cell balancing control signal CBS is at the second level.

As such, according to an embodiment, it is possible to reduce the current flowing in the central battery cell during the charging and discharging, thereby solving the problem that the charging and discharging are first terminated by the central battery cell.

While this invention has been described in connection with what is presently considered to be practical embodiments, it is to be understood that the invention is not limited to the disclosed embodiments. On the contrary, it is intended to cover various modifications and equivalent arrangements included within the spirit and scope of the appended claims.

## Claims

1. A cell balancing circuit connected to a plurality of cells connected in series, comprising:
a first switch, a first winding wire, and a second switch coupled in series between both terminals of a central battery cell including a centrally positioned cell in a plurality of cells; and
a third switch, a second winding wire, and a fourth switch coupled in series between a positive electrode of one and a negative electrode of the other one of the outer battery cell except the central battery cell among the plurality of cells,
wherein the first winding wire and the second winding wire form a transformer, and
during the charge or discharge, in a condition that the cell voltage difference between the central battery cell and the outer battery cell is greater than or equal to a predetermined threshold value, during the ON period of the first switch and the second switch, a first side current as a part of a charging current or a discharging current flows through the first switch, the first winding wire, and the second switch.

2. The cell balancing circuit of claim 1, wherein
in a condition that the cell voltage difference between the central battery cell and the outer battery cell during the charging is greater than or equal to a predetermined threshold value,
the first switch and the second switch are turned-on, an on duty of the first switch and the second switch is controlled based on the current flowing to the first winding wire, and the third switch and the fourth switch are turned-on after the turning-off of the first switch and the second switch.

3. The cell balancing circuit of claim 2, wherein
in a condition that the cell voltage difference between the central battery cell and the outer battery cell during the charging is greater than or equal to a predetermined threshold value,
in a turning on state of the first switch and the second switch, the first side current reaches a predetermined reference value, and the first switch and the second switch are turned-off.

4. The cell balancing circuit of claim 1, wherein
in a condition that the cell voltage difference between the central battery cell and the outer battery cell during the discharging is equal to or greater than a predetermined threshold value,
the third switch and the fourth switch are turned-on, an on duty of the third switch and the fourth switch is controlled based on the current flowing to the first winding wire, and the first switch and the second switch are turned-on after the turning-off of the third switch and the fourth switch.

5. The cell balancing circuit of claim 4, wherein
in a condition that the cell voltage difference between the central battery cell and the outer battery cell during the discharge is equal to or greater than a predetermined threshold value,
in the turning on state of the third switch and the fourth switch, when the second side current reaches a predetermined reference value, the third switch and the fourth switch are turned-off.

6. The cell balancing circuit of claim 1, further comprising:
a first diode connected between one terminal of the first switch and one terminal of the first winding wire; and
a second diode connected between one terminal of the second switch and the other terminal of the first winding wire,
the other terminal of the first switch is connected to the other terminal of the first winding wire, and the other terminal of the second switch is connected to one terminal of the first winding wire.

7. The cell balancing circuit of claim 1, further comprising:
a third diode connected between one terminal of the third switch and one terminal of the second winding wire; and
a fourth diode connected between one terminal of the fourth switch and the other terminal of the second winding wire,
the other terminal of the third switch is connected to the other terminal of the second winding wire, and the other terminal of the fourth switch is connected to one terminal of the second winding wire.

8. A battery system comprising:
a battery pack including a plurality of cells connected in series;
a cell monitoring IC for measuring a cell voltage of each of a plurality of cells;
a main control circuit that determines whether a deviation between a cell voltage of a central battery cell including the cell centrally positioned among a plurality of cells and the cell voltage of an outer battery cell except for the central battery cell among a plurality of cells is a predetermined threshold value or more based on a plurality of measured cell voltages, and controls a cell balancing operation based on the determined result and the charging and discharging of the battery pack; and
a cell balancing circuit that prevents a first current among a charging current from flowing to the central battery cell when the deviation is greater than the threshold value in the charging condition of the battery pack, and prevents a second current among a discharging current from flowing to the central battery cell when the deviation is greater than the threshold value in the discharge condition of the battery pack.

9. The battery system of claim 8, wherein
the cell balancing circuit includes:
a first switch, a first winding wire, and a second switch coupled in series between both terminals of the central battery cell; and
a third switch, a second winding wire, and a fourth switch coupled in series between a positive electrode of one and a negative electrode of the other one among the outer battery cells, and
the first winding wire and the second winding wire form a transformer.

10. The battery system of claim 8, wherein
the cell balancing circuit switches the first to fourth switches during a first period in which the deviation is larger than the threshold value during the charging period to store the energy in the first winding wire by the first current and to transmit the stored energy in the first winding wire to the second winding wire.

11. The battery system of claim 10, wherein,
during the first period, a first current flows in the first winding wire during an ON period of the first and second switches, and a current is induced to the second winding wire during an OFF period of the first and second switches and an ON period of the third and fourth switches.

12. The battery system of claim 8, wherein
the cell balancing circuit switches the first to fourth switches during a second period in which the deviation is larger than the threshold value among the discharge period to store the energy in the second winding wire and to transmit the stored energy in the second winding wire to the first winding wire.

13. The battery system of claim 12, wherein
during the second period, a current flows in the second winding wire during an ON period of the third and fourth switches, and a second current is induced to the first winding wire during an OFF period of the third and fourth switches and an ON period of the first and second switches.

14. The battery system of claim 8, wherein
the cell balancing circuit includes:
a first diode connected between one terminal of the first switch and one terminal of the first winding wire; and
a second diode connected to one terminal of the second switch and the other terminal of the first winding wire,
the other terminal of the first switch is connected to the other terminal of the first winding wire, and the other terminal of the second switch is connected to one terminal of the first winding wire.

15. The battery system of claim 8, wherein
the cell balancing circuit further includes:
a third diode connected between one terminal of the third switch and one terminal of the second winding wire; and
a fourth diode connected between one terminal of the fourth switch and the other terminal of the second winding wire,
the other terminal of the third switch is connected to the other terminal of the second winding wire, and the other terminal of the fourth switch is connected to one terminal of the second winding wire.
